## Europäisches Patentamt
## European Patent Office
## Office européen des brevets

(19)

(11) Veröffentlichungsnumm~ **0 040 314**
**A1**

(12) # EUROPÄISCHE PATENTANMELDUNG

(21) Anmeldenummer: 81102678.0

(22) Anmeldetag: 09.04.81

(51) Int. Cl.³: **G 01 R 15/02**
**H 01 B 17/52**

(30) Priorität: 21.05.80 DE 8013688 U

(43) Veröffentlichungstag der Anmeldung:
25.11.81 Patentblatt 81/47

(84) Benannte Vertragsstaaten:
AT BE CH DE FR GB IT LI LU NL SE

(71) Anmelder: **Karl Pfisterer Elektrotechnische**
**Spezialartikel GmbH & Co. KG**
**Augsburger Strasse 375**
**D-7000 Stuttgart 60(DE)**

(72) Erfinder: **Sander, Dieter**
**Malachitweg 12**
**D-7000 Stuttgart 75(DE)**

(72) Erfinder: **Schächterle, Werner**
**Forststrasse 26**
**D-7057 Winnenden(DE)**

(72) Erfinder: **Kübler, Karl**
**Kühäcker 4**
**D-7141 Freiberg(DE)**

(74) Vertreter: **Patentanwälte Dr. Wolff; H. Bartels**
**Dipl.-Chem. Dr. Brandes Dr.-Ing. Held; Dipl.-Phys. Wolff**
**Lange Strasse 51**
**D-7000 Stuttgart 1(DE)**

(54) **Prüfspitze für Spannungsprüfer.**

(57) Eine Prüfspitze für Spannungsprüfer mit einem Isolierrohr (4), das im Bereich seines einen Endes mit einem Spannungsprüfergehäuse (2,3) verbunden ist und an seinem freien Ende eine Prüfelektrode (5) aufweist, trägt auf dem Isolierrohr (4) axial verschiebbar eine bei einer axialen Verschiebung von der Oberfläche des Isolierrohres (4) Schmutz und Feuchtigkeit abstreifende Schutzvorrichtung (7). Diese Schutzvorrichtung weist wenigstens einen an der Außenmantelfläche des Isolierrohres (4) dicht anliegenden Ringkörper (23) auf, der aus einem weichen, elastisch verformbaren Werkstoff besteht, welcher mit einem flüssigen, wasserabstoßenden Mittel getränkt ist, das beim axialen Verschieben der Schutzvorrichtung (7) die Außenmantelfläche des Isolierrohres (4) benetzt.

5. März 1981
3330 rrp
Reg.-Nr.126 332

KARL PFISTERER ELEKTROTECHNISCHE SPEZIALARTIKEL GMBH & CO KG,
Augsburger Straße 375, 7000 Stuttgart 60 (DE)

Prüfspitze für Spannungsprüfer

Die Erfindung betrifft eine Prüfspitze für Spannungsprüfer
mit einem Isolierrohr, das im Bereich seines einen Endes mit
einem Spannungsprüfergehäuse verbunden ist und an seinem
freien Ende eine Prüfelektrode trägt.

Aus Sicherheitsgründen ist es bei Verwendung eines Spannungsprüfers mit einer Prüfspitze der vorstehend genannten Art
zumindest dann, wenn die Spannungsprüfung an Kompaktstationen durchgeführt wird, notwendig, vor dem Einführen der Prüfspitze in die dafür vorgesehene Prüföffnung der Kompaktstation die Prüfspitze mittels eines Tuches zu reinigen, um sowohl Schmutz als auch Feuchtigkeit zu entfernen. Es ist deshalb bei den bekannten Prüfspitzen der Sorgfalt des Monteurs überlassen, ob sich die Prüfspitze in sauberem und trockenem Zustand befindet und damit die Bedienungsperson nicht gefährdet ist, wenn die Prüfelektrode an den zu prüfenden Leiter herangeführt wird.

Der Erfindung liegt daher die Aufgabe zugrunde, eine Prüfspitze für Spannungsprüfer zu schaffen, deren gefahrloser Gebrauch zumindest weitgehend von der Sorgfalt des Benutzers unabhängig ist.

Diese Aufgabe löst eine Prüfspitze der eingangs genannten Art, bei der auf dem Isolierrohr axial verschiebbar eine bei der Axialverschiebung von der Oberfläche des Isolierrohres Schmutz und Feuchtigkeit abstreifende Schutzvorrichtung angeordnet ist, welche wenigstens einen an der Außenmantelfläche des Schutzrohres dicht anliegenden Ringkörper aufweist, der aus einem weichen, elastisch verformbaren Werkstoff besteht, welcher mit einem flüssigen, wasserabstoßenden Mittel getränkt ist, das beim axialen Verschieben der Schutzvorrichtung die Außenmantelfläche des Isolierrohres benetzt.

Die Bedienungsperson braucht also nur die Schutzvorrichtung auf dem Isolierrohr zu verschieben, um Schmutz und Feuchtigkeit zu entfernen und außerdem das erneute Befeuchten der Oberfläche des Isolierrohres zu verhindern. Hierdurch ist eine Gefährdung der Bedienungsperson, wie sie bei einer nicht vollständig von Schmutz und Feuchtigkeit freien Oberfläche des Isolierrohres durch die Bildung von Kriechstrompfaden besteht, ausgeschlossen. Vorteilhaft ist die erfindungsgemäße Lösung auch im Hinblick auf die einfache Handhabung der Schutzvorrichtung und ihre kostengünstige Herstellbarkeit. Weitere vorteilhafte Ausgestaltungen der erfindungsgemäßen Prüfspitze sind Gegenstand der Unteransprüche.

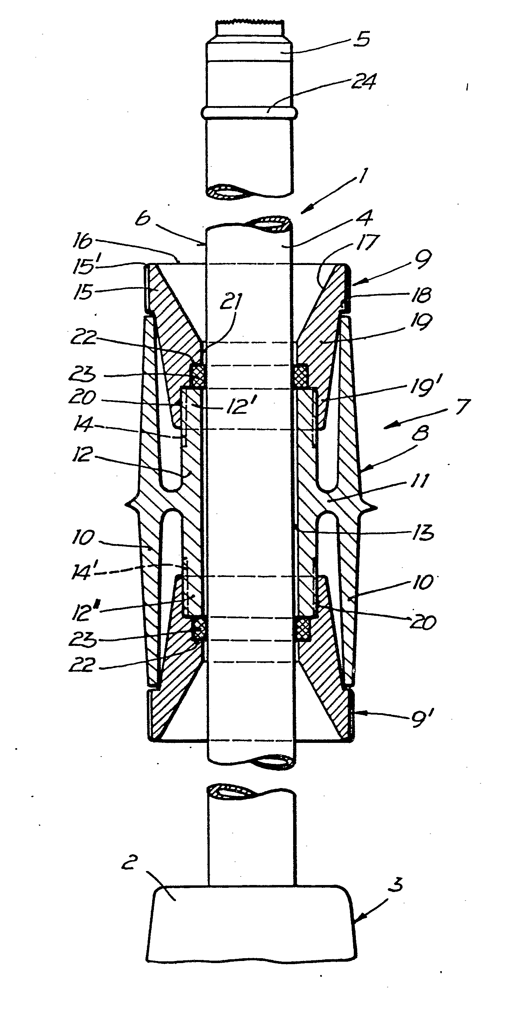

Im folgenden ist die Erfindung anhand eines in der Zeichnung dargestellten Beispiels im Einzelnen erläutert. Die einzige

- 3 -

Figur zeigt einen Längsschnitt des Ausführungsbeispiels.

Eine als Ganzes mit 1 bezeichnete Prüfspitze für einen Spannungsprüfer, der die Durchführung von Spannungsprüfungen auch in Kompaktstationen gestattet, also Stationen, bei denen die Spannung führenden Teile berührungssicher abgedeckt sind und die Prüfspitze zum Zweck einer Spannungsprüfung in eine Prüföffnung eingeführt werden muß, ist mit ihrem einen Ende in einen aus Isoliermaterial bestehenden Endabschnitt 2 eines Gehäuses 3 des Spannungsprüfers eingesetzt und mit diesem Endabschnitt verbunden. In der Bohrung des Endabschnittes 2, welche das Ende der Prüfspitze 1 aufnimmt, liegen in je einer Nut zwei nicht dargestellte O-Ringe, die an der Außenmantelfläche elektrisch dicht anliegen und dadurch das Gehäuse 3 zusammen mit der Prüfspitze 1 elektrisch dicht verschließen, d.h. die Bildung von Kriechströmen und die Bildung von Überschlägen zuverlässig verhindern.

Der Spannungsprüfer ist in bekannter Weise ausgebildet und deshalb im folgenden weder erläutert noch in der Figur dargestellt.

Die Prüfspitze 1 weist ein Isolierrohr 4 auf, an dessen dem Gehäuse 3 abgekehrten Ende in bekannter Weise eine Prüfelektrode 5 angeordnet ist, deren im Inneren des Isolierrohres 4 liegender, nicht dargestellter Schaftteil mit einem ebenfalls bekannten Widerstandskörper elektrisch leitend verbunden ist, der andererseits mit dem Eingang der im Inneren des Gehäuses 3 angeordneten Prüfschaltung verbunden ist. Die Außenmantelfläche 6 des Isolierrohres 4 ist, beispielsweise durch Überschleifen, geglättet und maßhaltig, und außerdem ist sie durch Lackieren porenfrei gemacht worden.

Auf dem Isolierrohr 4 ist längs verschiebbar eine als Ganzes mit 7 bezeichnete Schutzvorrichtung angeordnet, die/als Doppelisolator ausgebildet ist. Ein Mittelteil 8 der Schutzvorrichtung, welcher zwischen zwei baugleichen und durch je eine Buchse 9 bzw. 9' gebildeten Endabschnitten angeordnet ist und wie diese Buchsen aus Isoliermaterial, beispielsweise Kunststoff, besteht, weist eine Außenhülse 10 auf, welche einstückig über einem auf halber Länge vorgesehenen Ringsteg 11 mit einer konzentrisch zur Außenhülse 10 in dieser angeordneten Nabe 12 ausgebildet ist. Der Durchmesser der Nabenbohrung 13 ist etwas größer als der Außendurchmesser des Isolierrohres 4, so daß die Nabe das Isolierrohr nicht berührt. Wie die Figur zeigt, steht die Außenhülse 10 über beide Enden der Nabe 12 in gleichem Maße in axialer Richtung über. Ferner zeigt die Figur, daß der Außendurchmesser der Außenhülse 10 von der Mitte aus zu beiden Enden hin gleichmäßig und geringfügig abnimmt. Eine auf der Außenmantelfläche der Außenhülse 8 im Bereich des größten Außendurchmessers vorgesehene, an sich bekannte Abtropfkante erleichtert das Abtropfen von Wasser. Die Endabschnitte 12' und 12'' der Nabe 12 sind mit einem Außengewinde 14 bzw. 14' versehen. Auf diese beiden Außengewinde, welche beispielsweise als Feingewinde ausgebildet sein können, sind die Buchsen 9 und 9' aufgeschraubt, deren Bohrung deshalb im Bereich des einen Endabschnittes als korrespondierendes Innengewinde 20 ausgebildet ist. Wie die Figur zeigt, schließt sich an das Innengewinde 20 eine Ringnut 22 an, die nicht nur zum Isolierstab 4, sondern auch zu dem als Gewindebohrung ausgebildeten und mit dem Innengewinde 20 versehenen Endabschnitt hin offen ist. Auf die Ringnut 22 folgt zu dem der Nabe 12 abgewandten Ende der Buchse 9 bzw. 9' hin ein zylindrischer Abschnitt der Bohrung 21, deren Durchmesser an den Durchmesser der Bohrung 13 der Nabe 12 angepaßt ist, also etwas größer ist als der Außendurchmesser des Isolierrohres. Der anschließende Endabschnitt der Bohrung bildet einen sich zum freien Ende hin öffnenden Konus 17, wobei am freien Ende der Durchmesser nur wenig kleiner ist als der Außendurchmesser der Buchse, so daß hier eine Abtropfkante gebildet wird. Diese Abtropfkante verhindert, daß abgestreiftes Wasser wieder zurück auf die Oberfläche des Isolierrohres 4 gelangt.

Wie die Figur zeigt, nimmt der Außendurchmesser der Buchsen 9 und 9' von dem zwischen die Nabe 12 und die Außenhülse 10 eingreifenden Ende an gegen das andere Ende hin gleichmäßig zu bis zu einer Stelle, an der der Außendurchmesser etwa gleich dem Innendurchmesser der Außenhülse 10 im Bereich ihres Endes ist. Hier bildet die Buchse eine Ringschulter 18 als Übergang zu dem zylindrischen Endabschnitt, dessen Außendurchmesser an denjenigen der Außenhülse 10 an ihrem freien Ende angepaßt ist. Ist die Buchse 9 bzw. 9' vollständig auf die Nabe 12 aufgeschraubt, dann ist nur ein geringer Spalt zwischen der Ringschulter 18 und der ihr zugekehrten Stirnfläche der Außenhülse 10 vorhanden.

In der Ringnut 22 der beiden Buchsen 9 und 9' liegt je ein Ringkörper 23, der aus einem weichen, elastisch verformbaren und mit einer Flüssigkeit tränkbaren Werkstoff besteht. In dem Ausführungsbeispiel ist der Werkstoff ein Filz. Die beiden Ringkörper 23 sind mit Silikonöl getränkt. Die Innenmantelfläche des Ringkörpers 23 liegt selbst bei ungleichmäßigem Außendurchmesser des Isolierrohres 4 dicht an dessen Außenmantelfläche an. Das Einlegen des Ringkörpers 23 in die Ringnut 22 ist dadurch, daß diese zum Gewinde 20 hin offen ist, ohne weiteres möglich. Außerdem läßt sich dadurch, daß der Ringkörper auch an der Stirnfläche der Nabe 12 anliegt, der Druck, mit dem der Ringkörper 23 an der Außenmantelfläche des Isolierrohres 4 anliegt, dadurch einstellen, daß man die Buchse 9 bzw. 9' mehr oder weniger weit auf die Nabe 12 aufschraubt.

Zum Reinigen des Isolierrohres 4 wird die Schutzvorrichtung 7 in axialer Richtung hin- und hergeschoben. Dabei streifen die beiden Ringkörper 23 gegebenenfalls vorhandenen Schmutz und Feuchtigkeit ab. Gleichzeitig benetzen sie die Außenmantelfläche des Isolierrohres 4 gleichmäßig mit Silikonöl. Die Außenmantelfläche wird dadurch wasserabstoßend, so daß sich mit Sicherheit selbst bei Niederschlägen auf dem Isolierrohr kein Wasserfilm bilden kann. Der Kraftaufwand für die axiale Verschiebung der Schutzvorrichtung 7 ist gering.

Aus Sicherheitsgründen ist es zweckmäßig, vor dem Einführen der Prüfspitze 1 in eine Prüföffnung einer Kompaktstation nicht nur mehrmals die Schutzvorrichtung 7 über die gesamte Länge des Isolierrohres 4 hin- und herzuschieben, sondern danach die Schutzvorrichtung bis an einen Anschlag 24 nahe der Prüfelektrode 5 zu bringen, welcher im Ausführungsbeispiel durch einen Ringwulst gebildet ist. Beim Einführen der Prüfspitze 1 in die Prüföffnung liegt dann die Stirnfläche 16 der Gewindebuchse 9 an der Außenwand der Station an und gleitet auf dem Isolierrohr 4, so daß mit Sicherheit der in die Station ragende Abschnitt des Isolierrohres 4 frei von Schmutz und Feuchtigkeit ist. Außerdem ist hierdurch sichergestellt, daß keine Feuchtigkeit in das Innere der Station und damit an spannungsführende Teile gelangt, selbst dann nicht, wenn die Spannungsprüfung während Niederschlägen ausgeführt werden muß.

- . -

## Patentansprüche

1. Prüfspitze für Spannungsprüfer mit einem Isolierrohr (4), das im Bereich seines einen Endes mit einem Spannungsprüfergehäuse (2,3) verbunden ist und an sei:.m freien Ende eine Prüfelektrode (5) trägt, dadurch gekennzeichnet, daß auf dem Isolierrohr (4) axial verschiebbar eine bei einer axialen Verschiebung von der Oberfläche des Isolierrohres (4) Schmutz und Feuchtigkeit abstreifende Schutzvorrichtung (7) angeordnet ist, welche wenigstens einen an der Außenmantelfläche des Isolierrohres (4) dicht anliegenden Ringkörper (23) aufweist, der aus einem weichen, elastisch verformbaren Werkstoff besteht, welcher mit einem flüssigen, wasserabstoßenden Mittel getränkt ist, das beim axialen Verschieben der Schutzvorrichtung (7) die Außenmantelfläche des Isolierrohres (4) benetzt.

2. Prüfspitze nach Anspruch 1, gekennzeichnet durch wenigstens einen vom Ringkörper (23) gebildeten Abstreifring.

3. Prüfspitze nach Anspruch 1 oder 2, dadurch gekennzeichnet, daß der Werkstoff, aus dem der Ringkörper (23) besteht, Filz ist.

4. Prüfspitze nach einem der Ansprüche 1 bis 3, dadurch gekennzeichnet, daß das Mittel, mit dem der Ringkörper (23) getränkt ist, Silikonöl ist.

5. Prüfspitze nach einem der Ansprüche 1 bis 4, gekennzeichnet durch einen zweiten Ringkörper (23), der in Längsrichtung des Isolierrohres (4) im Abstand vom ersten Ringkörper (23) an der Schutzvorrichtung (7) vorgesehen und wie der erste Ringkörper (23) ausgebildet ist.

6. Prüfspitze nach einem der Ansprüche 1 bis 5, dadurch gekennzeichnet, daß die Schutzvorrichtung (7) als Doppelisolator ausgebildet ist.

7. Prüfspitze nach Anspruch 6 dadurch gekennzeichnet, daß der Doppelisolator aus Kunststoff; Gummi oder einem gummiähnlichen Werkstoff besteht.

8. Prüfspitze nach einem der Ansprüche 1 bis 7, dadurch gekennzeichnet, daß die Schutzvorrichtung (7) zwischen zwei durch je eine Buchse (9,9') gebildeten Endabschnitten einen Mittelteil aufweist, der aus einer das Isolierrohr (4) im Abstand umfassenden Nabe (12) und einer die Nabe konzentrisch im Abstand umgebenden sowie mit der Nabe (12) über einen Ringsteg (11) verbundenen Außenhülse (10) besteht.

9. Prüfspitze nach Anspruch 8, dadurch gekennzeichnet, daß die Innenbohrung jeder der beiden gleich ausgebildeten und das Isolierrohr (4) im Abstand umfassenden Buchsen (9,9') im Anschluß an einen mit einer Ringnut (22) zur Aufnahme des Ringkörpers (23) versehenen Abschnitt sich zu dem als Tropfkante ausgebildeten freien Ende hin erweitert.

10. Prüfspitze nach Anspruch 8 oder 9, dadurch gekennzeichnet, daß die Buchsen (9,9') auf den einen bzw. anderen Endabschnitt der Nabe (12) des Mittelteils aufgeschraubt sind und daß die den Ringkörper (23) aufnehmende Ringnut (22) zu der die Nabe (12) aufnehmenden Gewindebohrung (20) hin offen ist.

0040314

Europäisches
Patentamt

**EUROPÄISCHER RECHERCHENBERICHT**

ummer der Anmeldung

EP 81102678.0

| Kategorie | Kennzeichnung des Dokuments mit Angabe, soweit erforderlich, der maßgeblichen Teile | betrifft Anspruch |
|---|---|---|
| | **EINSCHLÄGIGE DOKUMENTE** | |
| A | DE - B - 1 915 372 (ALLMÄNNA SVENSKA) <br> + Patentanspruch 1 + <br> -- | |
| A | DE - B - 2 123 203 (PFISTERER) <br> + Spalte 2, Zeilen 4-8 + <br> -- | |
| A | DD - A - 119 493 (JURKE) <br> + Seite 2, Zeilen 11-15 + <br> -- | |
| A | DD - A - 126 850 (SCHUMANN) <br> + Seite 2, Zeilen 20-27 + <br> ---- | |

**KLASSIFIKATION DER ANMELDUNG (Int. Cl.³)**

G 01 R 15/02
H 01 B 17/52

**RECHERCHIERTE SACHGEBIETE (Int. Cl.³)**

G 01 R 1/00
G 01 R 15/00
G 01 R 19/00
H 01 B 17/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| WIEN | 21-08-1981 | KUNZE |

EPA form 1503.1 06.78